**Europäisches Patentamt**

**European Patent Office**

**Office européen des brevets**

(19)

(11) Numéro de publication : **0 011 700**
**B1**

(12) **FASCICULE DE BREVET EUROPÉEN**

(45) Date de publication du fascicule du brevet :
22.06.83

(51) Int. Cl.³ : **G 11 C 11/40**, G 11 C 8/00,
G 05 F 3/20

(21) Numéro de dépôt : 79103921.7

(22) Date de dépôt : 12.10.79

(54) **Dispositif pour l'alimentation des mémoires monolithiques.**

(30) Priorité : 30.11.78 FR 7834434

(43) Date de publication de la demande :
11.06.80 Bulletin 80/12

(45) Mention de la délivrance du brevet :
22.06.83 Bulletin 83/25

(84) Etats contractants désignés :
DE FR GB

(73) Titulaire : **International Business Machines Corporation**
**Armonk, N.Y. 10504 (US)**

(72) Inventeur : **Beranger, Hervé Léonard**
**13 rue Auguste Barbier**
**F-77300 Fontainebleau (FR)**
Inventeur : **Marzin, Claude**
**6 rue des Garennes**
**F-91540 Mennecy (FR)**
Inventeur : **Omet, Dominique Marcel**
**20 rue de la Montagne des Glaises**
**F-91100 Corbeil (FR)**
Inventeur : **Peter, Jean-Luc**
**9 rue de la Theuillerie**
**F-91130 Ris-Orangis (FR)**

(74) Mandataire : **Lattard, Nicole**
**COMPAGNIE IBM FRANCE Département de Propriété**
**Industrielle**
**F-06610 La Gaude (FR)**

(56) Documents cités :
DE A 2 756 267
US A 3 636 377
US A 3 688 280
US A 3 725 878
US A 3 732 440
US A 3 736 574
US A 4 057 789
US A 4 104 734
IBM TECHNICAL DISCLOSURE BULLETIN,
vol. 21, no. 4, septembre 1978, Armonk (US)

(56) Documents cites :
**BOUDON et al. : « Fast-Read Reference Scheme**
**for Multi Emitter (HARPER) Cell », pages 1476 à**
**1478**
**IBM TECHNICAL DISCLOSURE BULLETIN,**
**vol. 20, no. 11A, avril 1978, Armonk, (US) MAR-**
**CELLO : « Decode Circuit with Uplevel Clamp »,**
**pages 4406-4408**
**IBM TECHNICAL DISCLOSURE BULLETIN,**
**vol. 20, no. 8, janvier 1978, Armonk (US) BOU-**
**DON et al. « Top Line Selection Circuit in a**

Jouve, 18, rue St-Denis, 75001 Paris, France

Memory Cell », page 3155-3156
IBM TECHNICAL DISCLOSURE BULLETIN, vol. 14, no. 7, décembre 1971, Armonk (US) GELLER et al. : « Word Line Voltage Clamp », page 2096
IEEE JOURNAL OF SOLID-STATE CIRCUITS, vol. SC2, no. 4, décembre 1967, New York (US) IWERSEN et al. « Beam-Lead Sealed-Junction Semiconductor Memory with Minimal Cell Complexity », pages 196-201
ELECTRONICS, vol. 40, no. 4, 20 février 1967, New York, (US) CANNING et al. « Active Memory Calls for Discretion », pages 143-154

# 0 011 700

Dispositif pour l'alimentation des mémoires monolithiques

Description

## Domaine Technique

La présente invention concerne les mémoires monolithiques à lecture/écriture à accès aléatoire et elle concerne plus particulièrement un dispositif pour l'alimentation en puissance de telles mémoires permettant une réduction importante de la dissipation de puissance.

Les progrès de la technologie en matière d'intégration ont conduit à des densités de circuits très élevées qui sont particulièrement intéressantes pour la réalisation de mémoires. En effet, il est maintenant possible de fabriquer des mémoires à accès aléatoires comportant jusqu'à 10 000 cellules de mémoire et des circuits périphériques de commande et de détection, sur une même microplaquette. Dans un tel environnement il est évident que les problèmes liés à la dissipation de puissance sont très critiques et qu'en conséquence il faut réduire au minimum cette dissipation.

Ce problème s'est bien entendu déjà posé dans le passé et diverses solutions ont été proposées pour le résoudre.

## Techniques antérieures

Le brevet français N° 69 41886 déposé par la demanderesse le 4 décembre 1969 et publié le 9 octobre 1970 sous le N° 2 028 333, traite de la réduction de la puissance dissipée dans une mémoire dans laquelle toutes les cellules se trouvent intégrées, dans une seule microplaquette. Pour ce faire, la mémoire est divisée en plusieurs groupes de cellules. Chaque groupe est alimenté par une tension d'alimentation commune par l'intermédiaire d'une résistance. En conséquence, dans l'état non sélectionné le courant d'alimentation est faible et maintenu à une valeur suffisante pour que l'information soit conservée en mémoire. Un transistor est monté en parallèle sur la résistance de façon que dans l'état sélectionné, il shunte la résistance ce qui fait que les cellules du groupe sont alimentées sous tension constante avec un courant élevé de façon que les différentes opérations : lecture, écriture, etc. puissent être réalisées.

D'autres types d'alimentation sous courant faible lorsque les cellules ne sont pas sélectionnées sont aussi décrits dans deux articles parus dans la revue IBM Technical Disclosure Bulletin du 6 novembre 1971, volume 14, pages 1720 et 1721.

Dans ces dispositifs, la puissance dissipée est réduite aux dépens des caractéristiques des cellules qui se trouvent modifiées. En effet, du fait que le courant dans les cellules non actives est plus faible, l'immunité au bruit est diminuée de même que la vitesse de commutation.

## Exposé de l'invention

Un dispositif suivant le préambule de la revendication 1 est connu du US-A-3 732 440.

Le but de la présente invention est de réduire la puissance dissipée dans une telle mémoire monolithique du type à lecture/écriture sans modifier les caractéristiques de la mémoire par des moyens simples qui ne prennent pas trop de place sur la microplaquette.

Ce but est obtenu par l'objet de la revendication 1.

Conformément à la présente invention, la puissance dissipée dans une mémoire du type à lecture/écriture comportant des cellules formées de bascules bistables disposées en rangées et en colonnes est obtenue en alimentant les cellules sélectionnées sous un potentiel plus élevé que le potentiel d'alimentation des cellules non sélectionnées tout en maintenant le même courant de repos dans les cellules qu'elles soient sélectionnées ou non, de façon que l'immunité au bruit et la vitesse de commutation ne soient pas affectées.

Pour obtenir ce résultat, les lignes de mots des cellules de mémoire sont alimentées à partir de circuits à commutation de courant. Ces circuits comportent deux transistors ayant leurs émetteurs reliés entre eux, le point commun étant connecté à une ligne de mot. Le collecteur du premier transistor est connecté à un potentiel V1 de valeur extrême, par exemple la masse, et le collecteur du second transistor est connecté à un potentiel V2 de valeur intermédiaire entre V1 et V3, V3 étant l'autre potentiel des cellules de valeur extrême, par exemple égale à − 4,25 volts. La base du premier transistor est connectée à la sortie du décodeur commandant la sélection de la ligne de mot correspondante et la base du second transistor est connectée à une tension de référence. De cette façon, lorsque la ligne de mot est sélectionnée, le premier transistor est rendu conducteur, le second étant bloqué et les cellules reliées à cette ligne de mot sont alimentées entre les potentiels V1 et V3. Par contre, lorsque la ligne de mot n'est pas sélectionnée le premier transistor est bloqué, le second étant alors conducteur, les cellules sont alimentées entre V1 et V2. A ce changement de potentiel n'est pas associé un changement du courant dans les cellules, et on peut même fournir aux cellules un courant constant en utilisant des sources de courant.

# 0 011 700

## Brève description des figures

Les objets, caractéristiques et avantages de la présente invention ressortiront mieux de l'exposé qui suit, fait en référence aux dessins annexés à ce texte, qui représentent un mode de réalisation préféré de celle-ci.

La figure 1 représente l'arrangement d'une mémoire monolithique intégrée, dans lequel est incorporé le dispositif d'alimentation de la présente invention.

La figure 2 représente en détail le schéma d'une cellule qui peut être utilisée dans l'arrangement de la figure 1.

La figure 3 représente deux circuits permettant de fixer les niveaux sur les lignes de mots non sélectionnées et la ligne de mot sélectionnée.

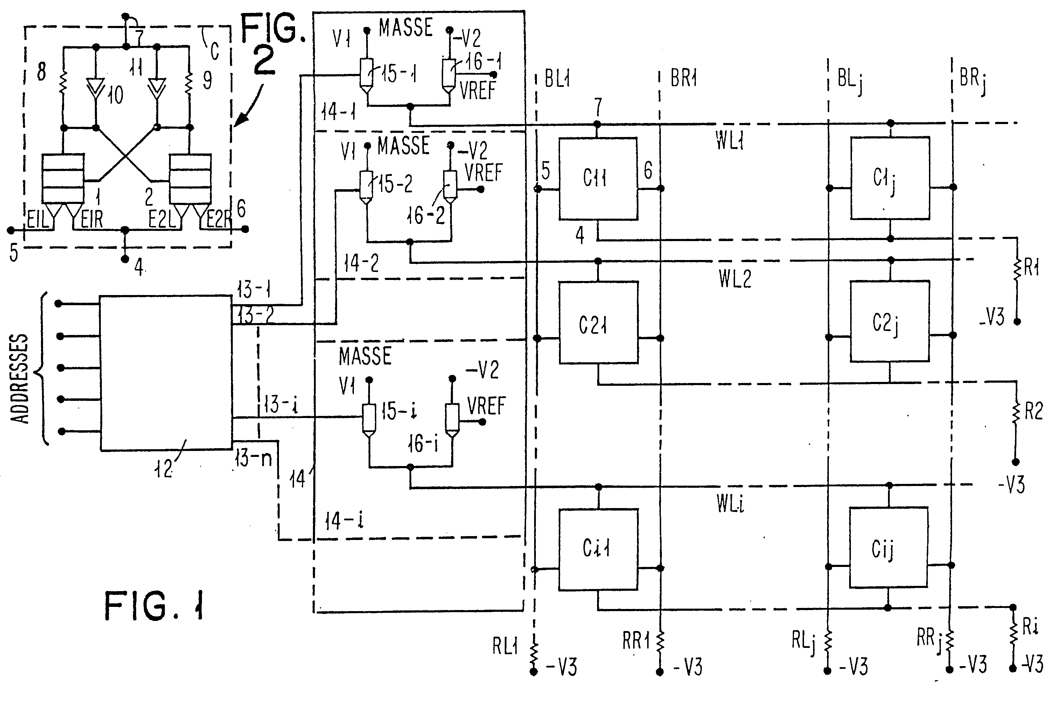

Le dispositif d'alimentation conforme à la présente invention est représenté sur la figure 1 incorporé dans une mémoire comprenant des cellules disposées en rangées et colonnes. Différents types de cellules formées de bascules bistables peuvent être utilisées mais on prendra à titre d'exemple pour illustrer le principe de la présente invention des cellules du type Harper.

Les cellules de Harper sont bien connues et on pourra se référer au brevet des E.U.A. N° 3 423 737 pour en avoir une description détaillée, on va cependant rappeler brièvement le principe d'une telle cellule qui est représentée sur la figure 2.

Une cellule de Harper C, comprend deux transistors 1 et 2 à deux émetteurs, ces deux transistors sont couplés en croix c'est-à-dire que le collecteur de l'un est relié à la base de l'autre. Les émetteurs E1R et E2L des transistors 1 et 2 sont reliés ensemble à une borne 4, les émetteurs E1L et E2R des transistors 1 et 2 sont reliés aux bornes 5 et 6 respectivement.

Les collecteurs des transistors 1 et 2 sont reliés à une borne 7 par l'intermédiaire des résistances 8 et 9 respectivement. Deux diodes de Schottky 10 et 11 sont montées en parallèle sur les résistances 8 et 9.

Dans une matrice de mémoire à n rangées et m colonnes les cellules C sont disposées en rangées et en colonnes comme représenté schématiquement sur la figure 2.

Six cellules sont représentées, C1l, C1j dans la première rangée, C2l, C2j dans la deuxième rangée, Cil et Cij dans la $i^{ème}$ rangée. Les bornes 4 à 7 de la cellule C1l ont été référencées pour montrer comment est montée une cellule de l'ensemble.

Toutes les bornes 4 des cellules d'une rangée sont connectées par une ligne commune. Chaque ligne commune est connectée par un puits de courant représenté schématiquement par une résistance R1, R2, ..., Ri, à une source d'alimentation de tension qui dans un mode de réalisation préféré est négative et égale à − 4,25 volts, cette tension est représentée par − V3 sur le dessin.

De même les bornes 5 des cellules d'une colonne sont reliées par des lignes communes BLl, BLj, à la source d'alimentation de tension négative par des résistances RLl et RLj respectivement. Il en est de même pour les bornes 6 qui sont connectées par des lignes communes BRl, BRj à la source de tension − V3 par les résistances RRl et RRj respectivement. Les lignes communes BL et BR sont les lignes de bits de gauche et de droite des cellules.

Les bornes 7 des cellules des différentes rangées sont connectées par les lignes communes WL1, WL2 et WLi qui sont les lignes de mots de la mémoire.

Dans une telle mémoire l'information binaire contenue dans chacune des cellules est représentée par l'état des transistors 1 et 2. Par exemple pour représenter un « 1 » binaire, le transistor 1 est conducteur et le transistor 2 est bloqué et pour représenter un « 0 » binaire, le transistor 1 est bloqué et le transistor 2 est conducteur.

Lorsque l'on veut sélectionner une cellule pour y écrire de l'information, c'est-à-dire changer l'état de la cellule, ou lire l'information contenue dans la cellule, la ligne de mot WL à laquelle est connectée la cellule doit être excitée, par exemple la ligne WLi, si l'on désire sélectionner la cellule Cij, puis l'information est lue ou écrite dans la cellule par l'intermédiaire de circuits de détection ou d'écriture connectés aux lignes de bits, par exemple aux lignes BLj et BRj, dans le cas de la cellule Cij. Les circuits de détection et d'écriture qui sont classiques et qui n'interviennent pas dans le fonctionnement du dispositif d'alimentation n'ont pas été représentés sur le dessin.

L'excitation des lignes de mots en vue de la sélection d'une rangée de cellules se fait par l'intermédiaire d'un décodeur d'adresses à l'entrée duquel sont appliquées les adresses binaires des lignes que l'on veut sélectionner.

Ce décodeur 12 a autant de sorties 13, qu'il y a de lignes de mots dans la mémoire, ces sorties sont référencées par 13-1, 13-2 et 13-i.

En conséquence lorsque l'on veut sélectionner la $i^{ème}$ rangée de cellules, les signaux d'adresses correspondants sont appliqués au décodeur 12 qui fournit un signal de niveau haut sur la ligne 13-i.

Les sorties du décodeur d'adresses sont reliées par l'intermédiaire du dispositif d'alimentation, conforme à l'invention 14, aux lignes de mots WL1, WL2 et WLi.

Le dispositif 14 est divisé en circuits élémentaires 14-1, 14-2, 14-i, etc., chacun correspondant à une ligne de mot, par exemple la sortie 13-i du décodeur est connectée à la ligne WLi par l'intermédiaire du circuit 14-i.

Chaque circuit élémentaire 14-i comprend un premier transistor 15-i et un second transistor 16-i. Ces deux transistors sont montés en commutateur de courant, c'est-à-dire qu'ils ont leurs émetteurs reliés

4

ensemble. La base du transistor 15-i est connectée à la ligne de sortie du décodeur 13-i et son collecteur est relié à une tension V1 qui dans un mode de réalisation est choisie égale à la masse. La base du transistor 16-i est reliée à une tension de référence dont la valeur est comprise entre les niveaux haut et bas apparaissant sur la ligne 13-i et son collecteur est relié à une tension d'alimentation négative représentée par − V2 dont la valeur est comprise entre V1 et − V3 et qui est choisie égale à − 1,50 volt pour une tension V1 égale à la masse et une tension − V3 égale à − 4,25 volts.

Le fonctionnement du dispositif d'alimentation est le suivant. Lorsque la sortie 13-i du décodeur est activée pour la sélection de la ligne de mot WLi, le niveau est haut sur la base du transistor 15-i qui est rendu conducteur, en conséquence de quoi le transistor 16-i est bloqué. Les cellules de la rangée ainsi sélectionnée, se trouvent alimentées entre la masse et − V3 égal à − 4,25 volts dans l'ensemble choisi.

Par contre dans les autres rangées non sélectionnées, par exemple dans la deuxième rangée, le niveau sur la ligne 13-2 est bas, ce qui fait que le transistor 15-2 est bloqué et le transistor 16-2 est conducteur. En conséquence les cellules de mémoire non sélectionnées sont alimentées sous 2,75 volts (4,25-1,50) au lieu de 4,25 volts dans le cas précédent, mais le courant peut être le même que pour les cellules sélectionnées du fait que les transistors 15 et 16 montés en commutateur de courant peuvent fournir les mêmes courants lorsqu'ils sont conducteurs. Ces courants sont déterminés par la différence de potentiel aux bornes de la résistance Ri. Le potentiel au nœud 4 suit d'un Vbv (Vbc étant la tension base-émetteur d'un transistor) celui de la ligne WLi qui lui-même suit le potentiel de base du transistor conducteur 15-i ou 16-i, selon que la ligne WLi est sélectionnée ou non. On peut choisir la tension de référence VREF très proche du niveau haut au nœud 13.

On peut aussi utiliser à la place de la résistance Ri, une source de courant constant, constitué par exemple par le courant collecteur d'un transistor dont l'émetteur est connecté à − V3 via une résistance et dont la base est portée à un potentiel fixe par rapport à − V3.

On s'intéresse dans tous les cas à la puissance totale dissipée à la fois dans les cellules de mémoire proprement dites et dans le dispositif conforme à la présente invention. Cette puissance produit du courant consommé par la tension totale utilisée, est réduite, puisque toutes les cellules non sélectionnées et les transistors 16 associés sont alimentés sous une tension totale moindre.

Pourtant, les caractéristiques des cellules sélectionnées et non sélectionnées restent les mêmes et principalement elles présentent la même immunité au bruit.

### Meilleure manière de réaliser l'invention

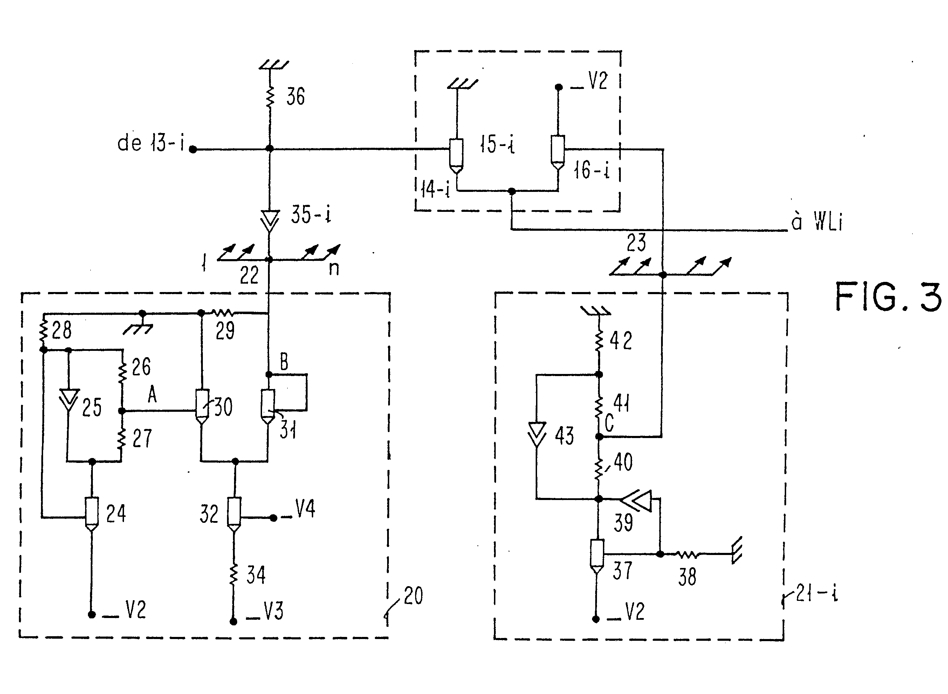

On va maintenant décrire en référence à la figure 3, un autre mode de réalisation de la présente invention dans lequel, l'alimentation des lignes de mots se fait toujours par l'intermédiaire de commutateurs de courant et qui comprend des circuits pour fixer les niveaux haut et bas sur ces lignes, à des valeurs qui améliorent encore les caractéristiques des cellules notamment du point de vue vitesse de lecture et d'écriture.

Sur la figure 3, on a représenté un élément 14-i du circuit 14 ainsi que le circuit 20 fixant le niveau haut sur la ligne de mot sélectionnée et un circuit 21-i fixant le niveau bas sur les lignes non sélectionnées. Étant donné que le circuit 20 n'est actif que lorsqu'une ligne est sélectionnée et qu'il n'y a toujours qu'une ligne sélectionnée à la fois, il n'y a qu'un circuit 20 pour un ensemble de mémoire à n rangées, ceci a été représenté schématiquement sur la figure par les flèches 22.

Pour fixer le niveau sur les lignes non sélectionnées, il est nécessaire de prévoir plusieurs circuits pour alimenter la base des transistors 16-1 à 16-n du fait qu'il y a toujours au moins n-1 des transistors 16 qui sont conducteurs. En conséquence, il est prévu un circuit 21 (identique au circuit 21-i représenté) pour alimenter quatre éléments commutateurs du courant du circuit 14. Ceci est représenté schématiquement par les flèches 23 sur le dessin à la sortie du circuit 21-i. Il est bien évident que ceci résulte d'un compromis, et qu'un nombre différent de circuits 21 peut être envisagé. Notamment si un circuit 21 peut débiter suffisamment de courant pour alimenter tous les transistors 16 des n commutateurs de courant un seul circuit 21 peut être utilisé.

Comme décrit dans le brevet des E.U.A. N° 3 423 737, pour lire ou écrire une information dans une cellule du type Harper telle que représentée sur la figure 2, un courant doit passer par l'un ou l'autre des émetteurs E1L et E2R d'un des transistors 1 et 2, contrairement à ce qui se passe pour les cellules non sélectionnées.

La sélection est réalisée en augmentant le potentiel sur la borne 7 de la cellule sélectionnée connectée à la ligne de mot.

Pour que la lecture soit réalisée.le plus rapidement possible il ne faut pas que l'excursion de tension sur la ligne de mot soit trop grande. Cependant pour écrire un mot sélectionné, il faut que le potentiel au nœud 7 d'une cellule non sélectionnée soit inférieur au potentiel le plus bas des deux nœuds 1 ou 2 d'une cellule sélectionnée.

Les circuits 20 et 21 ont pour fonction de remplir ces conditions.

Dans le circuit 20, le transistor 24, la diode de Schottky 25 et les résistances 26 et 27 fixent le potentiel au point A. Le transistor 24 a son émetteur relié à la tension − V2, sa base est connectée à l'anode de la diode 25 et son collecteur est connecté à l'autre borne de la diode. Deux résistances 26 et 27 sont montées en série, l'ensemble des deux résistances est en parallèle sur la diode 25. L'anode de la diode 25 est connectée à la masse par une résistance 28. Ce circuit fixe le potentiel au point A, qui est pris au point commun des résistances 26 et 27.

A partir du potentiel au point A, le potentiel sur la ligne de mot est fixé par les transistors 30, 31, 32 et les résistances 29 et 34. Le point A est connecté à la base du transistor 30. Les transistors 30 et 31 ont leurs émetteurs reliés ensemble et connectés au collecteur du transistor 32. Le transistor 32 est une source de courant dont l'émetteur est relié à la tension $-$ V3 par la résistance 34, sa base est connectée à une tension de polarisation $-$ V4 supérieure à $-$ V3.

Le collecteur du transistor 30 est relié à la masse. Le transistor 31 est monté en diode, sa base et son collecteur sont reliés et connectés à la masse par une résistance 29. Le collecteur du transistor 31 est connecté aux sorties 13-1 à 13-n du décodeur par l'intermédiaire de diode de Schottky 35, la diode 35-i associée à la sortie 13-i est représentée.

Comme on peut le voir sur la figure, le circuit 20, fournit au point B, pris au collecteur du transistor 31 une tension $V_A$ égale en valeur absolue à :

$$- V2 + V_{BE} (24) - 0,45 \, V_F (25)$$

$V_{BE}$ représente la tension base émetteur d'un transistor,

$V_{BE}$ (24) représentant la tension base-émetteur du transistor 24,

$V_F$ représente la tension d'une diode de Schottky,

$V_F$ (25) représentant la tension de la diode 25.

Le facteur 0,45 est donné par le rapport des résistances 26 et 27, R(26)/R(26 + 27).

La tension au point A se reproduit au point B du fait que le courant du transistor 32 se répartit entre les transistors 30 et 31.

Quand la $i^{ème}$ ligne de mot est sélectionnée la diode 35-i est conductrice, le courant dans cette diode est faible vis-à-vis du courant dans la résistance 29, si bien que les variations du courant dans la diode 35-i dues notamment aux variations du facteur $\beta$ du transistor 15-i ne modifient pas le potentiel au point B.

En conséquence, le potentiel sur la ligne de mot sélectionnée WLi est égal à en valeur absolue à :

$$V(\text{WLi sélectionnée}) = - V2 + V_{BE} (24) - 0,45 \, V_F (25)$$
$$+ V_F (35\text{-}i) - V_{BE} (15\text{-}i)$$
$$\simeq - V2 + 0,55 \, V_F.$$

Les circuits 21, qui fournissent la tension sur la base des transistors 16, sont constitués comme le circuit 21-i représenté sur la figure 3. Ce circuit fixe le niveau au nœud C, par des moyens similaires à ceux du circuit 20. Ces moyens comprennent un transistor 37, dont l'émetteur est relié à la tension $-$V2, la base est reliée d'une part à la masse par une résistance 38 et d'autre part au collecteur par une diode de Schottky 39. Le point commun du collecteur du transistor 37 et de la cathode de la diode 39 est connecté à la masse par trois résistances 40, 41, 42 montées en série. Les résistances 40 et 41 sont shuntées par une diode de Schottky 43 dont l'anode est connectée au point commun des résistances 42 et 41 et dont la cathode est connectée au collecteur du transistor 37. Le point commun des résistances 41 et 42 est référencé C. C'est ce point C qui est connecté aux bases des quatre transistors 16.

La tension $V_C$ au nœud C est égal en valeur absolue à :

$$V_C = - V2 + V_{BE} (37) - V_F (39) + 0,45 \, V_F (43)$$
$$= - V2 + V_{BE} (37) - 0,55 \, V_F$$

En conséquence le potentiel sur la $i^{ème}$ ligne de mot si elle est non sélectionnée, c'est-à-dire lorsque le transistor 16-i est conducteur et égal à

$$V(\text{WLi non sélectionné}) = - V2 + V_{BE} (37) - 0,55 \, V_F - V_{BE} (16\text{-}i)$$
$$= - V2 - 0,55 \, V_F$$

La différence entre les tensions sur les lignes de mots non sélectionnées et la ligne de mot sélectionnée est donc égale à 1,10 $V_F$, ce qui constitue une valeur correcte.

Il est à noter que cette différence de tension peut aisément être ajustée en modifiant les valeurs des résistances 26, 27 et 40, 41 des deux diviseurs.

## Revendications

1. Dispositif d'alimentation destiné à être utilisé dans un ensemble de mémoire monolithique constitué par une matrice de cellules (C) formées d'éléments bistables disposées en n rangées et m colonnes, les cellules des différentes rangées étant connectées à des lignes de mots (W) sélectionnées par un décodeur d'adresses (12), et comprenant :

n circuits de commutation de courants (14) chacun des circuits étant associé à une ligne de mot et à la sortie du décodeur d'adresses correspondante de façon à alimenter les cellules sous courant constant avec un premier potentiel (− V3) de valeur extrême quelque soit l'état des lignes de mots et à alimenter les lignes de mots sous deux potentiels différents, un potentiel élevé correspondant à l'état sélectionné de la ligne de mot et un potentiel faible correspondant à l'état non sélectionné, caractérisé en ce que chaque circuit de commutation comprend un premier commutateur (15) permettant de connecter la ligne de mot à un deuxième potentiel (V1) de valeur extrême dans l'état sélectionné et un deuxième commutateur (16) permettant de connecter la ligne de mot, à un troisième potentiel (− V2) de valeur intermédiaire dans l'état non sélectionné.

2. Dispositif selon la revendication 1 caractérisé en ce que chaque circuit de commutation de courant comprend un premier transistor (15) et un second transistor (16) dont les émetteurs sont reliés à la ligne de mot associée, la base du premier transistor est connectée à la sortie correspondante du décodeur, la base du second transistor est connectée à une tension de référence (VREF), le collecteur du premier transistor est connecté au deuxième potentiel, le collecteur du second transistor est connecté à la troisième tension de valeur intermédiaire (− V2).

3. Dispositif selon la revendication 2 caractérisé en ce que les cellules sont des cellules type Harper comprenant deux transistors à deux émetteurs, les deux transistors étant couplés en croix, la base de l'un étant connectée au collecteur de l'autre, les collecteurs de chacun des transistors sont connectés par des résistances à la ligne de mot associée, et un des émetteurs d'un transistor est connecté à un des émetteurs de l'autre, le point commun des deux émetteurs étant connecté par l'intermédiaire d'un générateur de courant au premier potentiel (− V3).

4. Dispositif selon l'une quelconque des revendications 2 ou 3 caractérisé en ce qu'il comprend :
un premier moyen (20) fixant le niveau haut sur la ligne de mot sélectionnée, ce moyen étant connecté aux bases des premiers transistors des circuits de commutation,
un second moyen (21) fixant le niveau bas sur les lignes de mot non sélectionnées, ce moyen étant connecté aux bases des seconds transistors des circuits de commutation.


**Claims**

1. Power-supply device designed to be used in a monolithic memory, consisting of a matrix of cells (C) formed of bistable elements laid out in n rows and m columns, the cells of different rows being connected to the word lines (W) selected by an address decoder (12), and including :
n current-switching circuits (14), each one of them being associated with a word line, and with the corresponding address decoder output so as to feed the cells at constant current under a first potential (− V3) of extreme value, whatever be the state of the word lines, and to feed the word lines under two different potentials, a high potential corresponding to the selected state of the word line and a low potential corresponding to the non-selected state, characterized in that each switching circuit includes a first switch (15) that enables the word line to be connected to a second potential (V1) of extreme value in the selected state and a second switch (16) that enables the word line to be connected to a third potential (− V2) of intermediate value in the non-selected state.

2. Device in accordance with claim 1, characterized in that each current-switching circuit includes a first transistor (15) and a second transistor (16), whose emitters are connected to the associated word line, the base of the first transistor is connected to the corresponding decoder output ; the base of the second transistor is connected to a reference voltage ($V_{REF}$), the collector of the first transistor is connected to the second potential and the collector of the second transistor is connected to the third potential of intermediate value (− V2).

3. Device in accordance with claim 2, characterized in that the cells are the « Harper cell » type, including two double-emitter transistors, the two transistors being cross-coupled, the base of one being connected to the collector of the other, the collectors of each transistor being connected by resistors to the associated word line, and one of the emitters of one transistor is connected to one of the emitters of the other, the common point of the two emitters being connected via a current generator to the first potentiel (− V3).

4. Device in accordance with either claim 2 or claim 3, characterized in that it includes :
a first means (20) fixing the high level on the selected word line, this means being connected to the bases of the first transistors of the switching circuits ;
a second means (21) fixing the low level on the non selected word lines, this means being connected to the bases of the second transistors of the switching circuits.


**Ansprüche**

1. Stromversorgungsvorrichtung für die Verwendung in einer monolithischen Speichereinheit, bestehend aus einer Matrize von Zellen (C), die aus in n Reihen und in m Spalten angeordneten bistabilen Elementen besteht, und in der die Zellen der verschiedenen Reihen an Wortleitungen (W) angeschlossen sind, die von einer Adreß-Dekodiervorrichtung (12) ausgewählt werden, und aus

n Stromumschaltkreisen (14), jeder Kreis einer Wortleitung und dem entsprechenden Adreß-Dekodiervorrichtungsausgang zugeordnet, um die Zellen unter konstantem Strom mit einem ersten Potential (− V3) mit extremem Wert so zu versorgen, unabhängig von dem Zustand der Wortleitung, und die Wortleitungen unter zwei verschiedenen Potentialen zu versorgen, wobei ein hohes Potential dem ausgewählten Zustand der Wortleitung und ein niedriges Potential dem nicht gewählten Zustand der Wortleitung entspricht, dadurch gekennzeichnet, daß jeder Schaltkreis einen ersten Schalter (15), mit dem sich die Wortleitung an ein zweites Potential (V1) von extremem Wert im ausgewählten Zustand schalten läßt und einem zweiten Schalter (16), mit dem sich die Wortleitung an ein drittes Potential (− V2) von einem mittleren Wert im nicht gewählten Zustand schalten läßt, aufweist.

2. Vorrichtung gemäß Anspruch 1, dadurch gekennzeichnet, daß jeder Stromschaltkreis einen ersten Transistor (15) und einen zweiten Transistor (16) aufweist, deren Emitter mit der zugeordneten Wortleitung verbunden sind, während die Basis des ersten Transistors an den entsprechenden Ausgang der Adreß-Dekodiervorrichtung und die Basis des zweiten Transistors mit einer Bezugsspannung (VREF) verbunden sind, während der Kollektor des ersten Transistors mit dem zweiten Potential, der Kollektor des zweiten Transistors mit der dritten Spannung mit einem mittleren Wert (− V2) verbunden sind.

3. Vorrichtung gemäß Anspruch 2, dadurch gekennzeichnet, daß die Zellen Zellen vom Typ Harper sind, mit zwei überkreuz miteinander verbundenen Transistoren mit je zwei Emittern ; und die Basis des einen an den Kollektor des anderen verbunden, die Kollektoren der beiden Transistoren sind durch Widerstände mit der zugeordneten Wortleitung verbunden, und einer der Emitter eines Transistoren ist an einen der Emitter des anderen verbunden, und der gemeinsame Punkt der beiden Emitter ist durch einen Stromgenerator mit dem ersten Potential (− V3) verbunden.

4. Vorrichtung gemäß einem der Ansprüche 2 und 3, dadurch gekennzeichnet, daß sie aufweist :

ein erstes Mittel (20), das mit den Basen der ersten Transistoren der Schaltkreise verbunden ist, um den oberen Spannungspegel an der gewählten Wortleitung festzustellen,

ein zweites Mittel (21), das mit den Basen der zweiten Transistoren der Schaltkreise verbunden ist, um den unteren Spannungspegel an den nicht gewählten Wortleitungen festzustellen.

FIG. 1

FIG. 2

FIG. 3

de 13-i

à WLi